# EUROPEAN PATENT APPLICATION

(11) **EP 4 742 569 A1**
(43) Date of publication of application: **13.05.2026**
(21) Application number: 25185249.7
(22) Date of filing: 25.06.2025
(51) Int. Cl.: H04L 1/00, G10L 19/00, H03M 7/30, H04L 1/1812, H04L 1/1867, H04W 4/80

(54) **WIRELESS COMMUNICATION DEVICE WITH PACKET-LEVEL ADAPTIVE BITRATE CONTROL AND ASSOCIATED WIRELESS COMMUNICATION METHOD**

(30) Priority: 07.11.2024 US 202463717290 P; 05.06.2025 US 202519228799
(71) Applicant: Airoha Technology Corp., 300 Hsinchu City (TW)
(72) Inventor: HSIEH, Ming-Yi, 308 Hsinchu County (TW)
(74) Representative: Hoefer & Partner Patentanwälte mbB

(57) **Abstract**

A wireless communication device (200) includes an encoder circuit (210) and a wireless communication circuit (212) . The encoder circuit (210) encodes the same input data to generate and output frames with different encoding quality. The wireless communication circuit (212) receives the frames from the encoder circuit (210), and transmits at least one frame selected from the frames to another wireless communication device (202) via a wireless link (204).

## Description

### CROSS REFERENCE TO RELATED APPLICATIONS

This application claims the benefit of U.S. Provisional Application No. 63/717, 290, filed on November 7th, 2024. The content of the application is incorporated herein by reference.

### BACKGROUND OF THE INVENTION

### 1. FIELD OF THE INVENTION

The present invention relates to wireless communications, and more particularly, to a wireless communication device with packet-level adaptive bitrate (ABR) control and an associated wireless communication method.

### 2. DESCRIPTION OF THE PRIOR ART

Lossless audio is the best form of audio as it has no drop in quality, and there is no quality degradation in the compression of the audio file. The lossless audio that the user hears is as good as the source material. However, lossless audio playback requests a high data rate for transmission of a lossless compressed audio bitstream from a source device to a sink device. To meet the high data rate requirement, the physical layer (PHY) throughput must be high, which requests a wider PHY bandwidth. However, it is difficult to maintain stability of audio under a wide PHY bandwidth in a noisy environment, which causes audio frame dropped and quality degradation on lossless audio playback.

Furthermore, throughput of transportation between the source device and the sink device may be limited and may change with time. Hence, a rate control scheme is generally employed to ensure that the bitstream is sent/received on time. For example, a typical rate estimation (RE) mechanism may be implemented on either the source side or the sink side. There is a response delay for reporting a rate estimation result of the RE mechanism to an encoder of the source device. In addition, there is a processing delay for the source-side encoder to actually change its output bitrate. Consider a case where throughput of transportation between the source device and the sink device changes to a lower level, causing an increase of the audio packet drop rate. Before the bitrate is actually reduced by the source-side encoder through the typical RE-based rate control scheme, the sink device may suffer audio dropout. Particularly, the bitrate control delay (which may include the response delay and the processing delay) is a big issue for low-latency uncompressed/lossless audio applications.

Thus, there is a need for an innovative ABR control scheme which does not use the typical RE mechanism and can meet requirements of low-latency uncompressed/lossless audio applications.

### SUMMARY OF THE INVENTION

One of the objectives of the claimed invention is to provide a wireless communication device with packet-level ABR control and an associated wireless communication method. A wireless communication device and a wireless communication method according to the invention are defined in the independent claims. The dependent claims define preferred embodiments thereof.

According to a first aspect of the present invention, an exemplary wireless communication device is disclosed. The exemplary wireless communication device includes an encoder circuit and a wireless communication circuit. The encoder circuit is arranged to encode a same input data to generate and output a plurality of frames with different encoding quality. The wireless communication circuit is arranged to receive the plurality of frames from the encoder circuit, and transmit at least one frame selected from the plurality of frames to another wireless communication device via a wireless link.

According to a second aspect of the present invention, an exemplary wireless communication method is disclosed. The exemplary wireless communication method includes: performing an encoding operation upon a same input data to generate and output a plurality of frames with different encoding quality; and transmitting at least one frame selected from the plurality of frames to a wireless communication device via a wireless link.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a diagram illustrating an audio codec (encoder-decoder) model with the proposed packet-level ABR control according to an embodiment of the present invention.
FIG. 2 is a diagram illustrating a wireless communication device using the proposed packet-level ABR control scheme according to an embodiment of the present invention.
FIG. 3 is a flowchart illustrating a packet-level ABR control method according to an embodiment of the present invention.
FIG. 4 is a diagram illustrating retransmission slots available between transmissions of two frames.
FIG. 5 is a diagram illustrating a scenario in which retransmission slots are used for retransmission of a previously transmitted frame with low quality/bitrate.
FIG. 6 is a diagram illustrating a scenario in which retransmission slots are reused for transmission of a not-yet-transmitted frame with high quality/bitrate.

### DETAILED DESCRIPTION

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

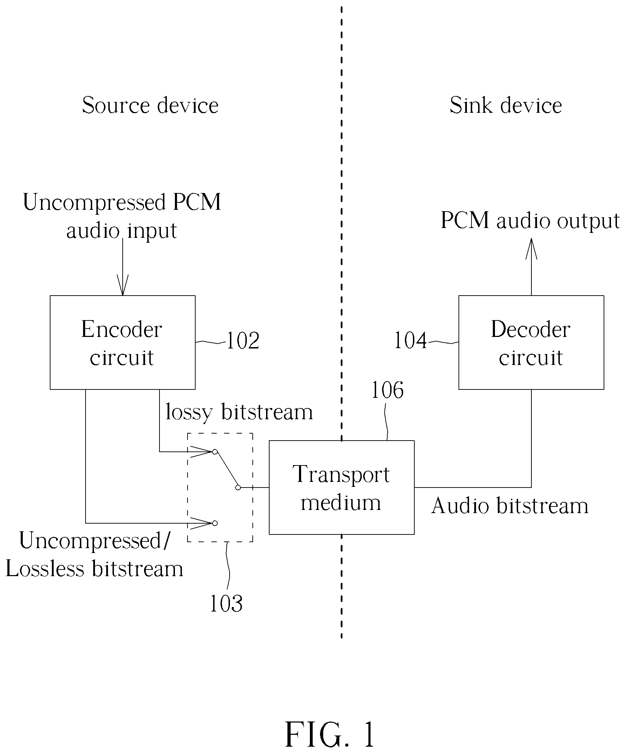

FIG. 1 is a diagram illustrating an audio codec (encoder-decoder) model with the proposed packet-level ABR control according to an embodiment of the present invention. An encoder circuit 102 (which is a part of an audio codec of a source device) gets an uncompressed pulse-code modulation (PCM) audio input, and encodes the uncompressed PCM audio input to generate a lossy bitstream (i.e., a bitstream generated from applying lossy compression to the uncompressed PCM audio input) and an uncompressed/lossless bitstream (i.e., a bitstream generated from applying no compression to the uncompressed PCM audio input, or a bitstream generated from applying lossless compression to the uncompressed PCM audio input). A selection circuit 103 selects at least one of the lossy bitstream and the uncompressed/lossless bitstream for transmission of an audio bitstream over a transport medium (e.g., a wireless link) 106, where a media access control (MAC) frame is encapsulated into a PHY packet and then transmitted over the transport medium 106. For example, the audio bitstream transmitted over the transport medium 106 may include the lossy bitstream followed by the uncompressed/lossless bitstream. For another example, the audio bitstream transmitted over the transport medium 106 may include the lossy bitstream only. A decoder circuit 104 (which is a part of an audio codec of a sink device) receives the audio bitstream from the transport medium (e.g., wireless link) 106, and decodes the received audio bitstream to generate a PCM audio output for audio playback at the sink device.

In this embodiment, the selection circuit 103 is controlled by an acknowledgement (ACK) or a negative-acknowledgement (NAK) received from the sink device. Hence, a packet-level ABR control is achieved at the source device. In addition, there is no typical RE mechanism implemented in any of the source device and the sink device. It should be noted that the audio codec model shown in FIG. 1 is for illustrative purposes only, and is not meant to be a limitation of the present invention. In practice, any wireless communication device using the proposed packet-level ABR control scheme (e.g., an RE-less bitrate control scheme) falls within the scope of the present invention.

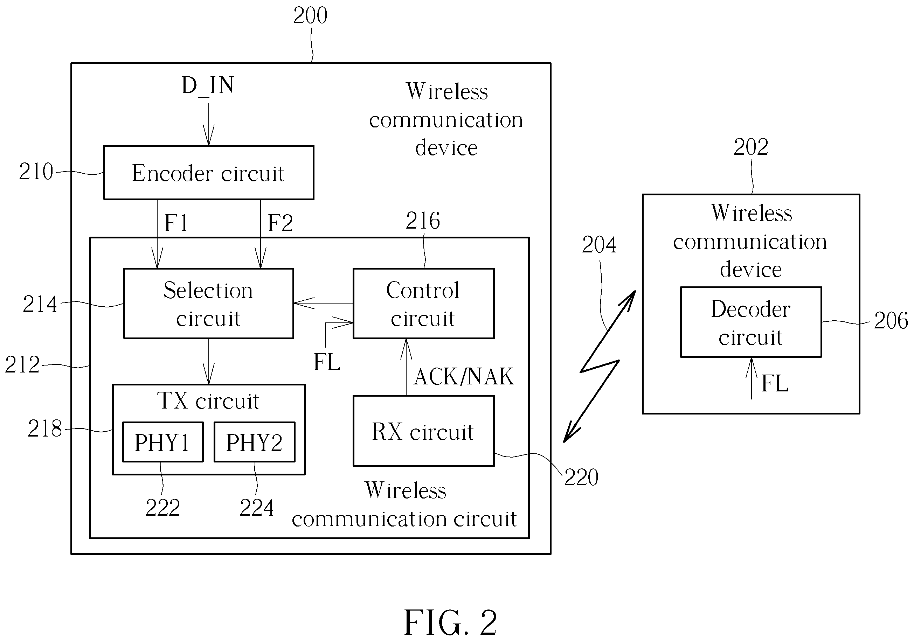

FIG. 2 is a diagram illustrating a wireless communication device using the proposed packet-level ABR control scheme according to an embodiment of the present invention. The packet-level ABR control scheme employed by the wireless communication device 200 is based on the audio codec model shown in FIG. 1. Specifically, the wireless communication device 200 is a source device with packet-level ABR control, and the wireless communication device 202 is a sink device that communicates with the source device via a wireless link 204. Preferably, the wireless communication device 200 is a sender that may be BT dongle, phone or laptop, and the wireless communication device 202 is a receiver that may be a headphone, a speaker, or an earbud. Preferably, the wireless link 204 may be a Bluetooth (BT) link. For example, the BT link may be a Low Energy (LE) Isochronous (ISO) Channel.

The wireless communication device 200 may include an encoder circuit (which is a part of an audio codec of the source device) 210 and a wireless communication circuit 212. The wireless communication circuit 212 may include a selection circuit 214, a control circuit 216, a transmit (TX) circuit 218, and a receive (RX) circuit 220. It should be noted that only the components pertinent to the present invention are illustrated in FIG. 2. In practice, the wireless communication device 200 may include additional components to achieve designated functions.

The encoder circuit 210 is arranged to encode the same input data D_IN to generate and output a plurality of frames with different encoding quality. In this embodiment, the encoder circuit 210 may support different compression modes, including lossy compression, lossless compression, and no compression. The wireless communication circuit 212 is arranged to receive the frames (which are generated from performing an encoding operation upon the same input data D_IN) from the encoder circuit 210, and transmit at least one frame selected from the received frames to the wireless communication device 202 via the wireless link 204. For example, the wireless communication circuit 212 may sequentially transmit all of the frames with different encoding quality (e.g., different bitrates) to the wireless communication device 202, thereby enabling high-quality audio playback at the sink device. For another example, the wireless communication circuit 212 may transmit only a portion of the frames with different encoding quality (e.g., different bitrates) to the wireless communication device 202, thereby enabling high-stability audio playback at the sink device.

For better comprehension of technical features of the present invention, the following assumes that the frames with different encoding quality (which are generated from performing an encoding operation upon the same input data D_IN) may include a first frame F1 with low encoding quality (e.g., low bitrate) and a second frame F2 with high encoding quality (e.g., high bitrate). The control circuit 216 may include a TX scheduler (not shown) for scheduling transmission of the first frame (e.g., low quality/bitrate frame) F1 and the second frame (e.g., high quality/bitrate frame) F2, where transmission of the second frame F2 may depend on a current channel status of the wireless link 204 and/or a setting of a flag FL. A decoder circuit 206 (which is a part of an audio codec of the sink device) receives an audio bitstream (which may include a PHY packet carrying the first frame F1, or may include a PHY packet carrying the first frame F1 and a subsequent PHY packet carrying the second frame F2) from the wireless link 204, and decodes the received audio bitstream to generate a PCM audio output for audio playback at the sink device. The PCM audio output may be generated from decoding the PHY packet carrying the first frame F1 if the audio bitstream includes no PHY packet carrying the second frame F2, or may be generated from decoding the PHY packet carrying the second frame F2 if the audio bitstream includes the PHY packet carrying the first frame F1 and the subsequent PHY packet carrying the second frame F2.

Preferably, the encoding operation performed upon the same input data D_IN may include lossy compression with a first compression setting and lossy compression with a second compression setting. Hence, the first frame (e.g., low quality/bitrate frame) F1 may be a lossy compressed frame, and the second frame (e.g., high quality/bitrate frame) F2 may also be a lossy compressed frame.

Alternatively or additionally preferably, the encoding operation performed upon the same input data D_IN may include lossy compression and lossless compression. Hence, the first frame (e.g., low quality/bitrate frame) F1 may be a lossy compressed frame, and the second frame (e.g., high quality/bitrate frame) F2 may be a lossless compressed frame. For example, the second frame (e.g., high quality/bitrate frame) F2 may be a lossless compressed frame including lossless compressed data only. For another example, the second frame (e.g., high quality/bitrate frame) F2 may be a lossless compressed frame including a plurality of subframes, where the subframes may include an uncompressed subframe and a lossless compressed subframe. Hence, the decoder circuit 206 of the wireless communication device 202 can do partial lossless decoding based on right subframes.

Alternatively or additionally preferably, the encoding operation performed upon the input data D_IN may include lossy compression and no compression. Hence, the first frame (e.g., low quality/bitrate frame) F1 may be a lossy compressed frame, and the second frame (e.g., high quality/bitrate frame) F2 may be an uncompressed frame.

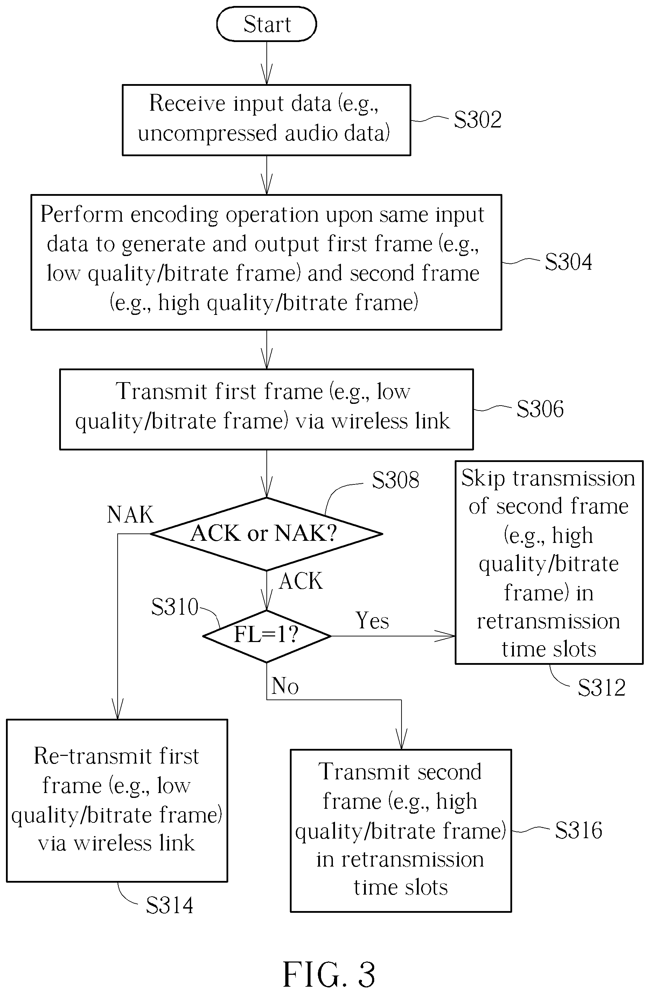

The control circuit 216 includes a TX scheduler that controls transmission of the first frame F1 and the second frame F2 to achieve packet-level ABR control. FIG. 3 is a flowchart illustrating a packet-level ABR control method according to an embodiment of the present invention. The packet-level ABR control method may be employed by the wireless communication device 200. Provided that the result is substantially the same, the steps are not required to be executed in the exact order shown in FIG. 3. At step S302, the encoder circuit 210 receives the input data D_IN. At step S304, the encoder circuit 210 performs an encoding operation upon the same input data D_IN to generate and output the first frame (e.g., low quality/bitrate frame) F1 and the second frame (e.g., high quality/bitrate frame) F2. At step S306, the wireless communication circuit 212 (particularly, selection circuit 214 of wireless communication circuit 212) receives the first frame F1 and the second frame F2 generated and output from the encoder circuit 210. In addition, the wireless communication circuit 212 (particularly, control circuit 216 of wireless communication circuit 212) instructs the selection circuit 214 to output the first frame F1 to the TX circuit 218, and instructs the TX circuit 218 to transmit the first frame F1 to the wireless communication device 202 via the wireless link 204. It should be noted that, no matter whether transmission of the second frame (e.g., high quality/bitrate frame) F2 is granted or not, the wireless communication device 200 will transmit the first frame (e.g., low quality/bitrate frame) F1 to the wireless communication device 202. In a case where the input data D_IN is audio data, transmission of the first frame (e.g., low quality/bitrate frame) F1 may offer audio dropout protection at the wireless communication device 202.

In this embodiment, the TX circuit 218 may have a plurality of separate PHY circuits, including a high stability PHY circuit (labeled by "PHY1") 222 and a high speed PHY circuit (labeled by "PHY2") 224. The high stability PHY circuit 222 is arranged to transmit a low quality/bitrate frame to the wireless communication device 202. The high speed PHY circuit 224 is arranged to transmit a high quality/bitrate frame to the wireless communication device 202. Hence, at step S306, the high stability PHY circuit 222 is activated to transmit the first frame F1 at a narrow PHY bandwidth for achieving high-stability transmission.

At step S308, the control circuit 216 determines whether the retransmission time slots is used for its original purposes (i.e., retransmission of the first frame F1) or reused for transmission of the second frame F2. Specifically, the use of retransmission time slots depends on whether the previously transmitted first frame F1 is successfully received by the wireless communication device 202. A NAK is used to specify which frame was expected but was not successfully received by a receiving end. An ACK is used to specify which frame was successfully received by the receiving end.

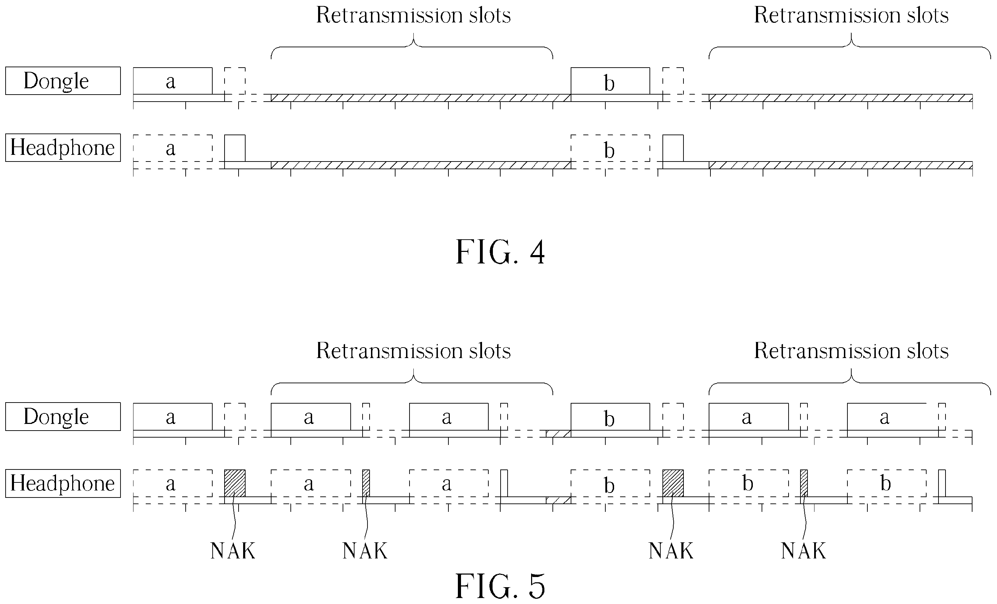

Consider a case where the RX circuit 220 receives an ACK from the wireless communication device 202 (step S308), where the ACK indicates that the previously transmitted first frame (e.g., low quality/bitrate frame) F1 is received by the wireless communication device 202. The flow proceeds to step S310. At step S310, the control circuit 216 checks a setting of the flag FL. The setting of the flag FL controls whether the function of transmitting the second frame F2 in retransmission slots should be skipped. FIG. 4 is a diagram illustrating retransmission slots available between transmissions of two frames a and b. A BT dongle (e.g., wireless communication device 200) may transmit a frame a/b to a BT headphone (e.g., wireless communication device 202). Considering a case where the frame a/b is transmitted in a clear environment, no packet loss occurs and no retransmission is requested by the BT headphone (e.g., wireless communication device 202), such that these retransmission slots originally defined for packet retransmission are free. In accordance with the proposed packet-level ABR control scheme, these free retransmission slots can be reused to transmit the second frame F2. However, it is possible that the BT dongle (e.g., wireless communication device 200) may use these free retransmission slots to transmit other data (e.g., non-audio data) to the BT headphone (e.g., wireless communication device 202). When the flag FL is set by a first logic value (e.g., FL=1), it indicates that the proposed packet-level ABR control scheme should be disabled, thereby allowing free retransmission slots to be reused for transmitting other data (e.g., non-audio data) to the BT headphone (e.g., wireless communication device 202). Hence, transmission of the second frame F2 in retransmission slots is skipped (step S312).

When the flag FL is set by a second logic value (e.g., FL=0), it indicates that the proposed packet-level ABR control scheme can be enabled, thereby allowing free retransmission slots to be reused for transmitting the second frame F2. Hence, the flow proceeds to step S316. At step S316, the control circuit 216 instructs the selection circuit 214 to output the second frame F2 to the TX circuit 218, and instructs the TX circuit 218 to transmit the second frame F2 to the wireless communication device 202 via the wireless link 204. As mentioned above, the TX circuit 218 may have a plurality of separate PHY circuits, including the high stability PHY circuit (labeled by "PHY1") 222 and the high speed PHY circuit (labeled by "PHY2") 224. Hence, at step S316, the high speed PHY circuit 224 is activated to transmit the second frame F2 at a wide PHY bandwidth for achieving high-speed transmission.

To put it simply, the wireless communication circuit 212 (particularly, control circuit 216 of wireless communication circuit 212) is further arranged to receive the flag FL, and determine whether to skip transmission of the second frame (e.g., high quality/bitrate frame) F2 in retransmission time slots according to the setting of the flag FL. It should be noted that the setting of the flag FL at the sink device (i.e., wireless communication device 202) is synchronized with the setting of the flag FL at the source device (i.e., wireless communication device 200). Hence, the wireless communication device 202 can refer to the setting of the flag FL to skip the function of decoding the second frame F2 in retransmission time slots. However, this is for illustrative purposes only, and is not meant to be a limitation of the present invention.

Consider another case where the RX circuit 220 receives a NAK from the wireless communication device 202 (step S308), where the NAK indicates that the previously transmitted first frame F1 is not received by the wireless communication device 202. In response to the NAK indicative of packet loss, the control circuit 216 instructs the TX circuit 218 to retransmit the first frame F1 in retransmission slots (step S314).

FIG. 5 is a diagram illustrating a scenario in which retransmission slots are used for retransmission of a previously transmitted frame a/b with low quality/bitrate. A BT dongle (e.g., wireless communication device 200) may transmit a frame a/b to a BT headphone (e.g., wireless communication device 202). For example, the frame a/b may be transmitted via a high stability PHY circuit. When the frame a/b is transmitted in a noisy environment, packet loss occurs, and retransmission is requested by the BT headphone (e.g., wireless communication device 202). Hence, the same frame a/b is retransmitted in the retransmission slots.

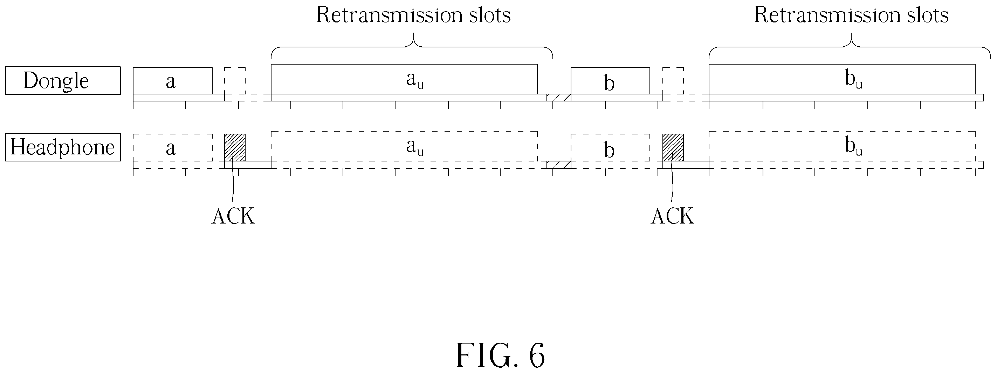

FIG. 6 is a diagram illustrating a scenario in which retransmission slots are reused for transmission of a not-yet-transmitted frame with high quality/bitrate. A BT dongle (e.g., wireless communication device 200) may transmits a frame a/b to a BT headphone (e.g., wireless communication device 202). For example, the frame a/b may be transmitted via a high stability PHY circuit. When the frame a/b is transmitted in a clear environment, no packet loss occurs and no retransmission is requested by the BT headphone (e.g., wireless communication device 202). Hence, the retransmission slots can be reused for transmission of the frame aᵤ/bᵤ. For example, the frame aᵤ/bᵤ may be transmitted via a high speed PHY circuit to save the transmission time since it has no impact on stability. Furthermore, since the frame aᵤ/bᵤ is sent in free retransmission slots, it has no impacts on frame a/b retransmission.

In accordance with the proposed packet-level ABR control scheme, the source device may encode a single input bitstream (e.g., an uncompressed PCM bitstream) to generate two bitstreams with different quality/bitrates (e.g., a first lossy bitstream and a second lossy bitstream, or a lossy bitstream and a lossless bitstream, or a lossy bitstream and an uncompressed bitstream) . A bitstream with low quality/bitrate (e.g., lossy bitstream) is first transmitted. A bitstream with high quality/bitrate (e.g., lossy bitstream, lossless bitstream, or uncompressed bitstream) is allowed to be transmitted only if a wireless link between the source device and the sink device has good quality. Thus, the source device may refer to availability of free retransmission slots to dynamically switch between transmission of the bitstream with low quality/bitrate only and transmission of the bitstream with low quality/bitrate and the bitstream with high quality/bitrate. Since the bitstream switch is handled in the source device, there is no rate estimation and almost no response delay. Specifically, seamless switch between stability-oriented transmission under a noisy environment and quality-oriented transmission under a clear environment without jumpiness can be achieved by using the proposed packet-level ABR control scheme. In addition, since the transmission priority of the bitstream with low quality/bitrate is higher than that of the bitstream with high quality/bitrate, the packet error rate (PER) for the bitstream with high quality/bitrate (e.g., lossless bitstream or uncompressed bitstream) is no longer a bottleneck.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A wireless communication device (200) comprising:
an encoder circuit (210), arranged to encode a same input data to generate and output a plurality of frames with different encoding quality; and
a wireless communication circuit (212), arranged to receive the plurality of frames from the encoder circuit (210), and transmit at least one frame selected from the plurality of frames to another wireless communication device (202) via a wireless link (204).

2. The wireless communication device (200) of claim 1, wherein the plurality of frames comprise a first frame with first encoding quality and a second frame with second encoding quality that is higher than the first encoding quality, and the at least one frame comprises the first frame.

3. The wireless communication device (200) of claim 2, wherein the wireless communication circuit (212) is further arranged to receive a negative-acknowledgment, in the following also referred to as NAK, indicating that the first frame is not received by the another wireless communication device (202), and retransmit the first frame in retransmission time slots in response to the NAK; and the at least one frame does not comprise the second frame.

4. The wireless communication device (200) of claim 2 or 3, wherein the wireless communication circuit (212) is further arranged to receive an acknowledgment, in the following also referred to as ACK, indicating that the first frame is received by the another wireless communication device (202); and the at least one frame further comprise the second frame, where the wireless communication circuit (212) transmits the second frame in retransmission time slots in response to the ACK.

5. The wireless communication device (200) of any one of claims 2 to 4, wherein the wireless communication circuit (212) comprises:
a plurality of separate physical layer, in the following also referred to as PHY, circuits, comprising:
a first PHY circuit (222), arranged to transmit the first frame; and
a second PHY circuit (224), arranged to transmit the second frame.

6. The wireless communication device (200) of any one of claims 2 to 5, wherein the wireless communication circuit (212) is further arranged to receive a flag, and determine whether to skip transmission of the second frame in retransmission time slots according to a setting of the flag.

7. The wireless communication device (200) of any one of claims 2 to 6, wherein the first frame is a lossy compressed frame; and/or
wherein the second frame is a lossy compressed frame or a lossless compressed frame, wherein preferably the lossless compressed frame comprises a plurality of subframes and the subframes comprise an uncompressed subframe and a lossless compressed subframe, or
wherein the second frame is an uncompressed frame.

8. The wireless communication device (200) of any one of claims 1 to 7, wherein the same input data is an uncompressed audio data.

9. The wireless communication device (200) of any one of claims 1 to 8, wherein the wireless link is a Bluetooth, in the following also referred to as BT, link;
wherein preferably the BT link is a Low Energy, in the following also referred to as LE, Isochronous, in the following also referred to as ISO, Channel.

10. The wireless communication device (200) of any one of claims 1 to 9, wherein the wireless communication device (200) is a dongle, a phone, or a laptop, and the another wireless communication device (202) is a headphone, a speaker, or an earbud.

11. A wireless communication method comprising:
performing an encoding operation upon a same input data to generate and output a plurality of frames with different encoding quality (S304); and
transmitting at least one frame selected from the plurality of frames to a wireless communication device via a wireless link (S306).

12. The wireless communication method of claim 11, wherein the plurality of frames comprise a first frame with first encoding quality and a second frame with second encoding quality that is higher than the first encoding quality, and the at least one frame comprises the first frame.

13. The wireless communication method of claim 12, further comprising:
receiving a negative-acknowledgment, in the following also referred to as NAK, indicating that the first frame is not received by the wireless communication device;
retransmitting the first frame in retransmission time slots in response to the NAK (S314);
wherein the at least one frame does not comprise the second frame.

14. The wireless communication method of claim 12, further comprising:
receiving an acknowledgment, in the following also referred to as ACK, indicating that the first frame is received by the wireless communication device;
wherein the at least one frame further comprise the second frame,
and the second frame is transmitted in retransmission time slots in response to the ACK (S316).

15. The wireless communication method of any one of claims 12 to 14, wherein the first frame is a lossy compressed frame; and/or the second frame is a lossy compressed frame, a lossless compressed frame, or an uncompressed frame.
